Europäisches Patentamt

European Patent Office

Office européen des brevets

(19)

(11) Veröffentlichungsnummer: **0 171 121**
A2

# (12) EUROPÄISCHE PATENTANMELDUNG

(21) Anmeldenummer: 85201253.3

(22) Anmeldetag: 30.07.85

(51) Int. Cl.⁴: **H 03 M 11/00**

(30) Priorität: **09.08.84 DE 3429309**

(43) Veröffentlichungstag der Anmeldung: **12.02.86
Patentblatt 86/7**

(84) Benannte Vertragsstaaten: **DE FR GB IT SE**

(71) Anmelder: **Philips Patentverwaltung GmbH,
Billstrasse 80, D-2000 Hamburg 28 (DE)**

(84) Benannte Vertragsstaaten: **DE**

(71) Anmelder: **N.V. Philips' Gloeilampenfabrieken,
Groenewoudseweg 1, NL-5621 BA Eindhoven (NL)**

(84) Benannte Vertragsstaaten: **FR GB IT SE**

(72) Erfinder: **Hücking, Ernst Eugen, Gilbergstrasse 30B,
D-5900 Siegen 31 (DE)**
Erfinder: **Klemmt, Karl-Heinz, Auf der Alm 33,
D-5900 Siegen 32 (DE)**

(74) Vertreter: **Poddig, Dieter et al, Philips Patentverwaltung
GmbH Billstrasse 80 Postfach 10 51 49,
D-2000 Hamburg 28 (DE)**

(54) Elektronische Dateneingabe-Tastatur mit galvanische Kontakte aufweisenden Tasten.

(57) Bei Martrix-Tastaturen, bei denen die Tasten mit galvanischen Kontakten jeweils an Kreuzungspunkten von Leitern angeordnet sind, wird in Reihe mit jedem Tastenkontakt ein Widerstand angeordnet, um ein N-key Rollover zu ermöglichen, d.h. die gleichzeitige Betätigung mehrerer Tasten in beliebiger Anordnung. Bei manchen technischen Realisierungen der Tastenkontakte, beispielsweise in Form von durch Siebdruck auf Kunststofffolien aufgebrachten elektrisch leitenden Materialien, müssen die Widerstände in gleicher Weise hergestellt werden, was jedoch nicht mit der erforderlichen geringen Toleranz möglich ist, um Phantomtasten sicher zu vermeiden. Daher wird erfindungsgemäss vorgeschlagen, die abgefragten Matrixleitungen auf einen Punkt niedriger Impedanz zu führen. Dadurch wird weitgehend eine Stromsteuerung angewendet, durch die auf der abgefragten Leitung keine Signalspannung entstehen kann, die über andere betätigte Tasten Rückwirkungen erzeugen kann. Der Punkt niedrigen Potentials wird zweckmässigerweise durch den invertierenden Eingang eines mit einem Widerstand gegengekoppelten Operationsverstärkers gebildet.

"Elektronische Dateneingabe-Tastatur mit galvanische
Kontakte aufweisenden Tasten"

Die Erfindung bezieht sich auf eine elektronische Dateneingabe-Tastatur mit galvanische Kontakte aufweisenden Tasten, die Kreuzungen einer Leitungsmatrix aus einer Anzahl Spaltenleitungen und einer Anzahl Zeilenleitungen zugeordnet sind und bei Betätigung jeweils eine der Spaltenleitungen mit einer der Zeilenleitungen über einen in Serie mit dem Kontakt geschalteten ohmschen Widerstand koppeln, wobei die Leitungen der einen Matrix-Koordinate (z.B. Spaltenleitungen) nacheinander aus einer Steuerschaltung mit einem Abtastimpuls beaufschlagt und die Leitungen der anderen Matrix-Koordinate (z.B. Zeilenleitungen) mittels einer Auswerteschaltung auf das Auftreten des Abtastimpulses abgefragt werden.

Eine solche Tastatur ist aus der FR-PS 2 449 388 bekannt.

Darin wird berücksichtigt, daß bei Tastaturen für die Dateneingabe heute allgemein eine Eigenschaft verlangt wird, die "N-key Rollover" genannt wird. Hierunter versteht man die Fähigkeit der Tastatur, beim Druck auf eine Taste stets das richtige, dieser Taste zugeordnete elektrische Signal abzugeben, ohne Rücksicht darauf, ob etwa vorher gedrückte Tasten inzwischen wieder losgelassen wurden oder nicht. Das Symbol N soll dabei aussagen, daß es beliebig viele (N) Tasten sind, die niedergehalten werden können, ohne daß die Funktion der (N+1)ten Taste gestört wird. Ein solches Verhalten der Tastatur wird heute für schnelles, beidhändiges Schreiben für unerläßlich gehalten, weil bei gewissen Sequenzen über eine Anzahl Anschläge hinweg die Tasten in schnellerer Folge

0171121

angeschlagen als losgelassen werden und dadurch zeitweilig mehrere Tasten gleichzeitig niedergedrückt sind, ohne daß bei der Erkennung der Reihenfolge, in der sie betätigt wurden, Fehler auftreten dürfen.

Die bekannte Tastatur ermöglicht ein N-Key-Rollover dadurch, daß in Reihe mit jeder Taste ein ohmscher Widerstand geschaltet und die Leitungen der anderen Matrix-Koordinate durch einen Widerstand gegen einen Bezugspunkt abgeschlossen werden, wobei alle Widerstände nominell den selben Wert haben und die Auswerteschaltung Komparatoren enthält, die das Signal auf der zugehörigen Leitung mit einem genau eingestellten Referenzwert vergleichen.

Für die Realisierung von Tastenschaltern mit galvanischen Kontakten sind verschiedene Möglichkeiten bekannt. Ein Beispiel einer galvanischen Tastatur, die in der eingangs genannten Druckschrift angegeben ist, ist die Membran-Tastatur. Hier sind die Kontaktpunkte gemeinsam mit den Verbindungsleitungen in Form von Flächenelementen aus elektrisch leitendem, siebdruckfähigem Material auf Kunststoffolien aufgedruckt. Die Kontaktflecken zweier Folien liegen einander zugewandt gegenüber, getrennt durch eine Abstandsfolie, die im Bereich jedes Kontaktfleckens gelocht ist. Drückt man auf einen Kontaktflecken, so berührt dieser durch das Loch in der Abstandsfolie hindurch den Kontaktflecken der gegenüberliegenden Folie.

Bei einer derartigen Membran-Tastatur ist es jedoch praktisch nicht möglich, diskrete Widerstände mit dem durch Siebdruck hergestellten Leitermuster einer solchen Kunststoffolie zu verbinden. Löten scheidet aus wegen der Temperaturempfindlichkeit der Folie und der Siebdruckpasten. Das "Bonden" von Chip-Widerständen, wie es bei Siebdruck-Leitermustern auf Keramik-Substraten üblich ist, kommt nicht in Betracht aus verschiedenen Gründen (zu hoher Aufwand, nur auf harten Substraten anwendbar, mechanisch empfindlich). Gegen das "Crimpen" mit Metallklammern oder ähnlichem sprechen Proleme der Zuverlässigkeit und des Platzbedarfs.

Es bleibt also nur übrig, die Widerstände ebenfalls im Siebdruckverfahren aufzubringen. Derartige Widerstände weisen aber große Toleranzen von $\pm$ 30 % und mehr auf, die mit wirtschaftlichen Maßnahmen nicht verringert werden können und die sehr viel größer sind als die in der FR-PS 2 449 388 geforderten $\pm$ 5 %. Bei Widerständen mit den genannten großen Toleranzen ist es aber nicht möglich, bei der bekannten Tastatur zuverlässig in der Auswerteschaltung zu unterscheiden, ob das auf der zugehörigen Leitung empfangene Signal von einer tatsächlich betätigten Taste stammt oder eine Phantom-Taste darstellt.

Aufgabe der Erfindung ist es, eine elektronische Dateneingabe-Tastatur der eingangs genannten Art anzugeben, die ein beliebiges "N-key Rollover" bzw. eine abrollende Tastaturbedienung mit beliebig vielen gleichzeitig gedrückten Tasten auch bei großen Toleranzen der mit den Tasten in Reihe geschalteten ohmschen Widerständen ermöglicht und die sehr einfach aufgebaut ist und insbesondere auch für Membran-Tastaturen mit im Siebdruckverfahren hergestellten Leiterbahnen auf Kunststoffolien geeignet ist.

Diese Aufgabe wird erfindungsgemäß dadurch gelöst, daß die abgefragten Koordinatenleitungen mit je einem Punkt mit niedriger Impedanz verbunden sind und daß der Wert des ohmschen Widerstandes groß gegenüber dem der niedrigen Impedanz ist. Der Grundgedanke der Erfindung besteht in

0171121

jedem Fall darin, daß zumindest während der Dauer der Abfrage sämtliche Zeilenleitungen mit Punkten niedriger Impedanz verbunden sind.

Durch die erfindungsgemäßen Maßnahmen wird nämlich erreicht, daß anstatt mit der üblichen Spannungssteuerung im wesentlichen mit Stromsteuerung gearbeitet wird, so daß auf den abgefragten Koordinatenleitungen nur sehr geringe Spannungen entstehen und somit auch die Erscheinung von "Phantomtasten" sicher vermieden wird.

Es ist zweckmäßig, daß die galvanischen Tastenkontakte aus im Siebdruckverfahren auf Kunststoffolien aufgebrachten Kontaktflächen bestehen und daß die in Serie mit jedem Tastenkontakt angeordneten ohmschen Widerstände ebenfalls im Siebdruckverfahren aufgebracht sind. Auf diese Weise lassen sich die der Entkopplung der einzelnen Tasten dienenden Elemente zuverlässig und ohne Beschädigung der Kunststoffolie aufbringen, und außerdem ergibt diese Maßnahme ein besonders kostengünstiges Herstellungsverfahren. Tastaturen, bei denen die galvanischen Tastenkontakte aus Kontaktflecken auf Kunststoffolien bestehen, die im Siebdruckverfahren aufgebracht sind, sind an sich bekannt.

Der Punkt mit niedriger Impedanz kann auf verschiedene Weise realisiert werden, beispielsweise durch einen niederohmigen Widerstand gegen einen Bezugspunkt, wobei die abgefragen Koordinatenleitungen auf den Eingang eines Verstärkers mit ausreichender Verstärkung wie beispielsweise Operationsverstärker führen müssen. Eine andere Realisierung der Punkte niedriger Impedanz ist nach einer weiteren Ausgestaltung der Erfindung dadurch gekennzeichnet, daß jeder Punkt niedriger Impedanz durch den invertierenden Eingang eines Operationsverstärkers gebildet ist, dessen Ausgang über mindestens einen weiteren ohmschen Widerstand ebenfalls mit dem invertierenden Eingang verbunden ist und dessen nichtinvertierender Eingang eine feste Referenzspannung erhält. Auf diese Weise wird der Operationsverstärker nicht nur zur Verstärkung, sondern gleichzeitig auch zur Bildung des Punktes niedriger Impedanz verwendet. Die Referenzspannung muß ungleich der Impulsspannung sein, mit der die Spalten zur Ermittlung der gedrückten Tasten beaufschlagt werden.

Der invertierende Eingang eines auf diese Weise gegengekoppelten Operationsverstärkers stellt jedoch nur so lange einen Punkt mit niedriger Impedanz dar, wie das Ausgangssignal des Operationsverstärkers noch im linearen Verstärkungsbereich ist. Um zu verhindern, daß der Operationsverstärker z.B. durch Bauelementetoleranzen übersteuert wird, ist es zweckmäßig, daß parallel zum weiteren Widerstand eine Diode, vorzugsweise Z-Diode, zwischen Ausgang und invertierendem Eingang jedes Operationsverstärkers angeordnet ist. Dadurch wird das Ausgangssignal des Operationsverstärkers begrenzt, und der Eingang stellt auch bei höherem Eingangsstrom stets einen Punkt niedriger Impedanz dar.

Durch das Verbinden der abgefragten Koordinatenleitungen mit je einem Punkt mit niedriger Impedanz sind diese Koordinatenleitungen gleichzeitig verhältnis unempfindlich gegenüber von außen eingestreute elektrische Signale. Wenn eine weitere Vergrößerung dieser Störsicherheit gewünscht wird, ist es zweckmäßig, daß parallel zum weiteren Widerstand ein Kondensator zwischen Ausgang und invertierendem Eingang jedes Operationsverstärkers angeordnet ist. Dadurch wirkt der Operationsverstärker gleichzeitig als Integrator, der besonders unempfindlich gegenüber kurzen Signalimpulsen am Eingang ist.

Ausführungsbeispiele der Erfindung sind in den weiteren Zeichnungen dargestellt. Es zeigen

Fig. 1 das Prinzipschaltbild einer erfindungsgemäßen Tastatur,

Fig. 2 eine erweiterte Beschaltung der dabei verwendeten Operationsverstärker.

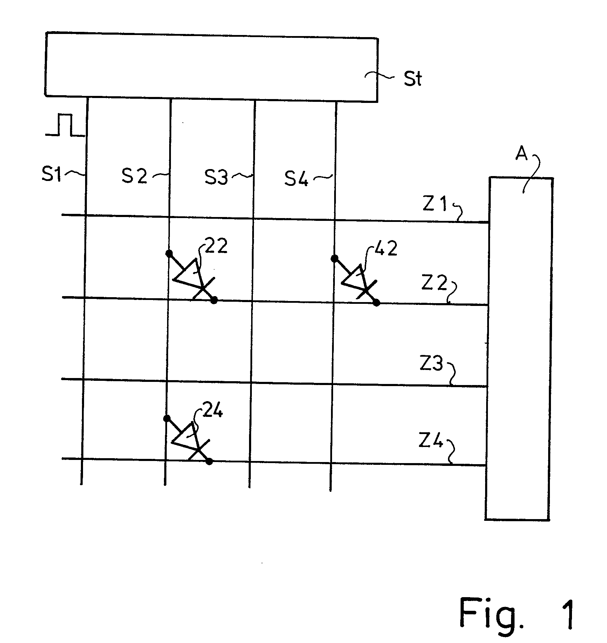

Die Fig. 1 zeigt als Beispiel wiederum eine Schaltermatrix der Größe 4 x 4, bei der nur drei geschlossene Schalter 22, 24 und 42 dargestellt und die übrigen zur Erläuterung als geöffnet angenommene Schalter weggelassen sind. Die Spaltenleitungen S1 bis S4 werden durch den Steuerteil ST in zeitlicher Folge mit Abtastimpulsen beaufschlagt. Die Zeilenleitungen Z1 bis Z4 sind mit je einem Punkt niedriger Impedanz verbunden, der in dem dargestellten Ausführungsbeispiel durch den invertierenden Eingang je eines der Operationsverstärker OP1 bis OP4 dargestellt wird.

Unter einem Operationsverstärker versteht man bekanntlich ein lineares Verstärkerelement, dessen Verstärkung so hoch ist und dessen sonstige Eigenschaften denen des idealen Verstärkers für eine gegebene Anwendung so nahe kommen, daß sein Verhalten in der Schaltung allein durch die externen Bauelemente bestimmt ist. Übliche Verstärker dieser Art haben außer einem Ausgang einen invertierenden und einen nicht invertierenden Eingang.

Wie Fig. 1 zeigt, sind die Zeilenleitungen mit den invertierenden Eingängen (-) der Operationsverstärker verbunden. Zwischen Ausgang und invertierendem Eingang jedes Verstärkers liegt außerdem in Widerstand r, der eine negative Rückkopplung bewirkt. Der nicht invertierende Eingang (+) ist mit einer festen Referenzspannung verbunden, hier als Beispiel mit dem gemeinsamen Bezugspotential der gesamten Schaltung, d.h. dem Massepotential.

Eine solche Konfiguration hat bekanntlich die Eigenschaft, daß der invertierende Eingang einen sogenannten virtuellen Massepunkt darstellt. Wegen der hohen Verstärkung des Verstärkerelementes bleibt nämlich die Potentialdifferenz zwischen den beiden Eingängen stets vernachlässigbar klein, solange der Verstärker im linearen Aussteuerbereich arbeitet. Der invertierende Eingang hat damit die Eigenschaft eines Summierpunktes, in den aus verschiedenen Quellen Ströme einfließen können, ohne daß sein Spannungspotential sich gegenüber dem Bezugspotential am nicht invertierenden Eingang verschiebt.

In Fig. 1 ist weiter in Serie mit jedem Tastenschalter ein Widerstand R geschaltet. Die Wirkungsweise der Anordnung ist folgende:

Erscheint der Abtastimpuls, der durch den Steuerteil ST in zeitlicher Folge an die verschiedenen Spaltenleitungen S1 bis S4 gelegt wird, beispielsweise an der Spalte S4, so fließt während der Dauer des Impulses ein Strom über den geschlossenen Tastenschalter 42 und den nachgeschalteten Widerstand R in den Summierpunkt am invertierenden Eingang (-) des Operationsverstärkers OP2. Dies hat zur Folge, daß der Abtastimpuls mit umgekehrter Polarität am Ausgang von OP2 erscheint, und zwar mit einer Amplitude, die in an sich bekannter Weise durch das Verhältnis r : R bestimmt wird.

Da nun, wie bereits erläutert, der invertierende Eingang (-) einen virtuellen Massepunkt darstellt, bleibt das Spannungspotential der Zeilenleitung 2 unbeeinflußt, d.h. der Abtastimpuls tritt hier als Spannungsimpuls nicht mehr auf. Damit gibt es auch trotz des geschlossenen Tastenschalters 22 keine Rückwirkung von Z2 auf S2 und weiter, so daß kein Phantom am Kreuzungspunkt S4, Z4 mehr

0171121

auftritt. Die Matrix ist frei von Phantomen in allen Betriebszuständen, weil jede Zeilenleitung mit einem virtuellen Massepunkt verbunden ist.

Die Auswertung der an den Ausgängen der Operationsverstärker nunmehr invertiert auftretenden Abtastimpulse erfolgt in gewohnter Weise durch den Abfrageteil A.

Die Realisierung der Punkte niedriger Impedanz ist nicht auf das bevorzugte Ausführungsbeispiel nach Fig. 1 beschränkt. So können beispielsweise die Operationsverstärker weggelassen und die Zeilenleitungen durch je einen ohmschen Widerstand mit dem Bezugspotential verbunden werden, wobei hierfür ein Widerstandswert zu wählen ist, der klein ist im Vergleich zu R. Hierdurch verläßt man zwar den Idealzustand eines virtuellen Massepunktes, aber es gelingt, die nunmehr an den Zeilenleitungen wieder auftretenden Impulsspannungen so klein zu halten, daß Rückwirkungen auf die Spaltenleitungen auch bei großen Toleranzen der Widerstände R wirksam vermieden werden. Zur Auswertung müssen dann diese kleinen Impulsspannungen nachverstärkt werden, was beispielsweise innerhalb des Abfrageteils geschehen kann.

Es ist auch möglich, nur einen Operationsverstärker zu verwenden und diesen mit Hilfe eines Analog-Multiplexers zyklisch mit den verschiedenen Zeilenleitungen zu verbinden. Der Multiplexer muß dabei so beschaffen sein, daß die jeweils nicht mit dem Operationsverstärker verbundenen Zeilenleitungen direkt mit dem Bezugspotential niederohmig verbunden sind, damit Rückwirkungen auf die Spaltenleitungen vermieden werden.

Im übrigen können Spalten und Zeilen vertauscht angeordnet sein; es ist dies nur eine Frage der zeichnerischen Darstellung. Weiter können bei dem Ausführungsbeispiel nach Fig. 1 die nicht invertierenden Eingänge (+) der Operationsverstärker statt mit dem gemeinsamen Bezugspotential, d.h. dem Massepotential der gesamten Schaltung, mit einer anderen festen Referenzspannung verbunden werden, wobei die Referenzspannung sich lediglich von der Impulsspannung des Abtastimpulses unterscheiden muß. Hierdurch verschieben sich u.a. die Gleichspannungspotentiale an den Ausgängen der Operationsverstärker, was aus Gründen der Pegelanpassung an den Abfrageteil A erwünscht sein kann. Auch kann der Abfrageteil A zusätzliche Mittel zur Pegelanpassung der Ausgänge der Operationsverstärker an die Eingänge üblicher Logik-Bauteile enthalten.

Bei Operationsverstärkern der Konfiguration in Fig. 1 stellt der invertierende Eingang bekanntlich nur so lange einen virtuellen Massepunkt dar, wie der Verstärker in seinem linearen Aussteuerbereich arbeitet. Sobald der Verstärker übersteuert wird, bricht die Verstärkung auf einen Wert nahe Null zusammen, und es kommt keine negative Rückkopplung über den Widerstand r mehr zustande. Dadurch entfernt sich das Potential am invertierenden Eingang von dem am nicht invertierenden Eingang, und es ist eine Rückwirkung über die anderen gleichzeitig geschlossenen Tastenkontakte möglich. Die Schaltung muß deshalb unter Berücksichtigung aller Toleranzen so bemessen werden, daß niemals ein Operationsverstärker übersteuert wird.

Gelingt dies bei den gegebenen Bauelemente-Toleranzen nicht, so kann die Übersteuerung dadurch verhindert werden, daß in an sich bekannter Weise eine Halbleiterdiode zwischen Ausgang und invertierendem Eingang jedes Operationsverstärkers angeordnet wird.

0171121

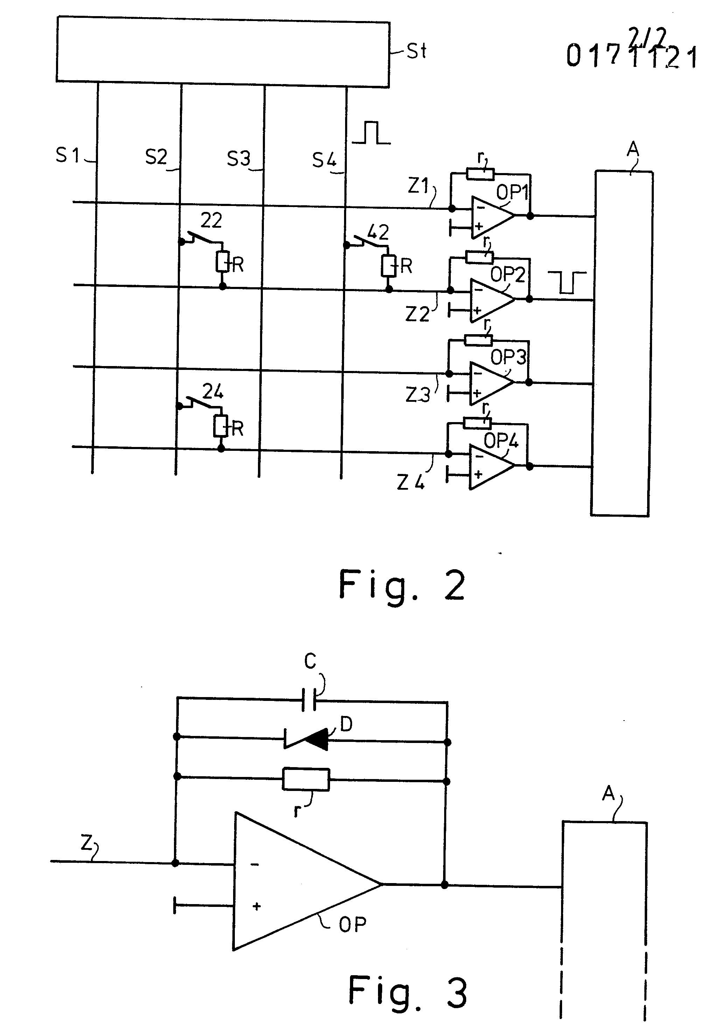

Diese Maßnahme wird anhand der Fig. 2 erläutert. Die Figur zeigt einen Operationsverstärker OP, der mit einer Zeilenleitung Z und dem Abfrageteil A verbunden ist. Parallel zu dem Rückkopplungswiderstand r ist eine Halbleiterdiode D angeordnet. Dies kann je nach der beabsichtigten Wirkung jede geeignete Diode oder eine Kombination von mehreren sein. Im vorliegenden Beispiel ist mit besonderem Vorteil eine Z-Diode vorgesehen, weil diese eine beidseitige Begrenzungswirkung ergibt. Bei dem dargestellten Beispiel wird die Ausgangsspannung des Verstärkers in positiver Richtung auf den Wert der Vorwärts-Durchlaßspannung (etwa 0,6 V) begrenzt und in negativer Richtung auf den Wert der Rückwärts-Durchbruchspannung, der vom gewählten Typ abhängt. Diese Begrenzung wird vor Erreichen der Übersteuerungsgrenze des Verstärkers dadurch erreicht, daß die Diode leitend wird, so daß die Rückkopplungsschleife voll in Funktion bleibt und die Eigenschaft des virtuellen Massepunktes am invertierenden Eingang erhalten bleibt.

Von Tastaturen wird heute verlangt, daß sie gegen Funktionsstörungen durch äußere elektrische Signale geschützt sind. Solche Signale können beispielsweise von elektrostatischen Entladungen oder in der Nähe betriebenen elektrischen Geräten herrühren. Auch in dieser Hinsicht ist die Tastatur gemäß der Erfindung im Vorteil, denn die Zeilenleitungen sind extrem niederohmig und neigen deshalb weniger dazu, in unerwünschter Weise als Empfangsantennen für derartige Störsignale zu wirken, als dies bei höheren Impedanzen der Fall ist. Falls erwünscht, kann dieser Vorteil noch vergrößert werden durch eine Maßnahme, die ebenfalls aus Fig. 2 hervorgeht. Es ist dies die Zufügung des Kondensators C parallel zum Widerstand r. Dieser Kondensator, der gemeinsam mit der Diode D oder ohne diese eingesetzt werden kann, verleiht der Verstärkeranordnung in an sich bekannter Weise Tiefpaßcharakter, was die Verstärkung der vorwiegend im Bereich hoher Frequenzen liegenden Störsignale weiter herabsetzt, ohne die sonstige Funktion zu beeinträchtigen.

Die beschriebene Anordnung wird mit besonderem Vorteil bei Membrantastaturen angewendet, bei denen, wie eingangs beschrieben, die Widerstände R mit den üblichen Widerstandspasten im Siebdruckverfahren auf die gleichen Folien aufgedruckt werden, die die Kontaktflecken tragen, wodurch nur Widerstandswere mit großen Toleranzen herstellbar sind. Die Verwendung der Widerstände R ist aber nicht auf Membrantastaturen beschränkt, sondern wird mit Vorteil angewendet bei allen Bauarten, bei denen die Anbringung von Widerständen mit engen Toleranzen in der Matrix Schwierigkeiten bereitet.

Dies trifft insbesondere auch auf Tastaturen mit Schaltmatten aus Silikongummi zu, wo der Platz zwischen den Kalotten oft zu knapp ist und auch Kontaktierungsschwierigkeiten bestehen. Auch hier können die Widerstände R im Siebdruckverfahren auf die bei dieser Bauart vorhandene gedruckte Schaltungsplatine aufgebracht werden.

PATENTANSPRÜCHE

1.    Elektronische Dateneingabe-Tastatur mit galvanische Kontakte aufweisenden Tasten, die Kreuzungen einer Leitungsmatrix aus einer Anzahl Spaltenleitungen und einer Anzahl Zeilenleitungen zugeordnet sind und bei Betätigung jeweils eine der Spaltenleitungen mit einer der Zeilenleitungen über ein in Serie mit dem Kontakt geschalteten ohmschen Widerstand koppeln, wobei die Leitungen der einen Matrix-Koordinate (z.B. Spaltenleitungen) nacheinander aus einer Steuerschaltung mit einem Abtastimpuls beaufschlagt und die Leitungen der anderen Matrix-Koordinate (z.B. Zeilenleitungen) mittels einer Auswerteschaltung auf das Auftreten des Abtastimpulses abgefragt werden, dadurch gekennzeichnet, daß die abgefragten Koordinatenleitungen mit je einem Punkt (Z1 bis Z4) mit niedriger Impedanz verbunden sind und daß der Wert des ohmschen Widerstandes (R) groß gegenüber dem der niedrigen Impedanz ist.

2.    Elektronische Dateneingabe-Tastatur nach Anspruch 1, dadurch gekennzeichnet, daß die galvanischen Tastenkontakte aus im Siebdruckverfahren auf Kunststoffolien aufgebrachten Kontaktflecken bestehen und daß die in Serie mit jedem Tastenkontakt angeordneten ohmschen Widerstände (R) ebenfalls im Siebdruckverfahren aufgebracht sind.

3.    Elektronische Dateneingabe-Tastatur nach Anspruch 1 oder 2, dadurch gekennzeichnet, daß jeder Punkt (Z1 bis Z4) niedriger Impedanz durch den invertierenden Eingang eines Operationsverstärkers (OP1 bis OP4) gebildet ist, dessen Ausgang über mindestens einen weiteren ohmschen Widerstand (r) ebenfalls mit dem invertierenden Eingang verbunden ist und dessen nichtinvertierender Eingang eine feste Referenzspannung erhält.

4.    Elektronische Dateneingabe-Tastatur nach Anspruch 3, <u>dadurch gekennzeichnet,</u> daß parallel zum weiteren Widerstand (r) eine Diode (D), vorzugsweise Z-Diode, zwischen  Ausgang und invertierendem Eingang jedes Operationsverstärkers (OP) angeordnet ist.

5.    Elektronische Dateneingabe-Tastatur nach Anspruch 3 oder 4, <u>dadurch gekennzeichnet,</u> daß parallel zum weiteren Widerstand (r) ein Kondensator (c) zwischen Ausgang und invertierendem Eingang jedes Operationsverstärkers (OP) angeordnet ist.

Fig. 1

Fig. 2

Fig. 3